Europäisches Patentamt

European Patent Office

Office européen des brevets

(11) Veröffentlichungsnummer: **0 155 396**
A2

# EUROPÄISCHE PATENTANMELDUNG

(21) Anmeldenummer: 84115796.9

(51) Int. Cl.⁴: **H 03 L 7/08**

(22) Anmeldetag: 19.12.84

(30) Priorität: 01.03.84 DE 3407582

(43) Veröffentlichungstag der Anmeldung:
25.09.85 Patentblatt 85/39

(84) Benannte Vertragsstaaten:
CH DE FR GB IT LI SE

(71) Anmelder: DORNIER SYSTEM GmbH
Postfach 1360
D-7990 Friedrichshafen(DE)

(72) Erfinder: Jacobi, Klaus
Sägestrasse 3
D-7994 Langenargen(DE)

(74) Vertreter: Landsmann, Ralf, Dipl.-Ing.
Kleeweg 3
D-7990 Friedrichshafen 1(DE)

(54) Schaltungsanordnung für einen Regelkreis.

(57) Die Schaltungsanordnung für einen Regelkreis enthält eine mit einem AFC- und Costas-Phasendetektor und einem gemeinsamen Integrator-Schleifenfilter kombinierte Regelschleife. Hierbei werden von AFC- und Costas-Phasendetektor (4, 7) abgegebene Fehlerspannungen vor dem gemeinsamen Integrator-Schleifenfilter (9) addiert.

Fig. 1

EP 0 155 396 A2

DORNIER SYSTEM GMBH

7990 Friedrichshafen


Reg. S 466



Schaltungsanordnung für einen Regelkreis


Die Erfindung betrifft eine Schaltungsanordnung für einen Regelkreis, enthaltend eine mit einem AFC- und Costas-Phasen-Detektor und einen gemeinsamen Integrator-Schleifenfilter kombinierte Regelschleife.


Bei Schaltungsanordnungen zur Verbesserung des Aquisitionsverhaltens durch eine automatische Frequenzregelung (AFC) der Costas-Phasen-Regelschleife (PLL) ergeben sich Probleme, welche eine Realisierung der Verbesserung ausserordentlich erschweren. Diese Probleme werden durch Offset-Spannungen des AFC-Detektors verursacht.
Derartige Schaltungsanordnungen sind z.B. beschrieben in IEEE Transactions on Communications, Vol. Com - 25, No. 12, Dec. 1977.

Die Funktionsweise dieser Anordnung besteht darin, dass bei Einrasten der Costas-Schleife der Frequenzfehler gewollt zu Null absinkt und der AFC-Detektor ebenfalls keine Spannung abgibt. Daraus folgt, dass auch die gefilterte und verstärkte Spannung am Summationspunkt Null ist. Dadurch wird der weitere Regelvorgang der Costas-Schleife nicht gestört. Dies gilt für die Funktionsweise der Schaltungsanordnung unter idealen Bedingungen.

Die Ausgangsspannung des AFC-Detektors ist aber tatsächlich unter realen Bedingungen nicht Null, sondern es tritt eine Offset-Spannung auf, welche z.B. durch eine ungleichmässige Rauschleistungsdichte, einem unsymmetrischen Modulationsspektrum des Eingangssignals, Gleichspannungsoffsets u.a. hervorgerufen wird. Die Offset-Spannung bewirkt nach Filterung - im Idealfall durch einen Integrator mit Übertragungsfunktion $F_1(s) = \frac{1}{s \cdot T_1}$ zur Minimierung des Restregelfehlers - eine stetige Änderung der Spannung am Summationspunkt der Regelspannungen. Dieser Änderung begegnet die Costas-Schleife durch eine gegenläufige Spannung, da sie den gerasteten Zustand der Schleife zu erhalten trachtet, was sich darin äussert, dass die Abstimmspannung für den spannungsabgestimmten Oszillator (VCO) unverändert bleibt. Dieser Ablauf funktioniert nur solange, bis irgendeine der beiden Regelspannungen die Aussteuerungsgrenze der Operationsverstärker oder eine Arbeitspunktverschiebung der Detektoren erreicht, wodurch das Regelsystem zusammenbricht und eine neue Aquisition eingeleitet werden muß.

Aufgabe der Erfindung ist, die bekannte Schaltungsanordnung in ihrer Funktion so zu verbessern, dass die vom AFC- und Costas-Phasen-Detektor ausgehenden Fehlerspannungen durch ein gemeinsames Schleifenfilter integriert und vor der Integration summiert werden.

Erfindungsgemäß wird die gestellte Aufgabe durch die kennzeichnenden Merkmale von Anspruch 1 gelöst.
Eine vorteilhafte Weiterbildung ergibt sich aus den Merkmalen des Unteranspruchs.

Der Vorteil der Erfindung besteht in der damit erzielbaren besseren Rauschbefreiung der AFC-Korrekturspannung und der kleineren Rauschbandbreite, bezogen auf die Eigenfrequenz der AFC-Schleife. Offset-Spannungen, die natürlich im AFC-Detektor entstehen können, bewirken im Gegensatz zu bisher bekannten Regelsystemen kein periodisches Ausrasten mehr. Das heisst, dass damit das Aquisitionsverhalten an AFC-Costas-Phasenregelschleifen auf einfache Weise wesentlich verbessert wird, was dadurch die bisherigen Schaltungen nicht oder nur mit grossem elektrischen Schaltungsaufwand möglich war.

Ein Ausführungsbeispiel ist folgend beschrieben und durch Skizzen erläutert.

Es zeigen:

Figur 1   ein Blockschaltbild der Schaltungsanordnung
          einer AFC- und Costas-Schleife,

Figur 2   eine im Prinzip eine vor der AFC- und Costas-
          Schleife geschaltete Schleifenfilteranordnung.


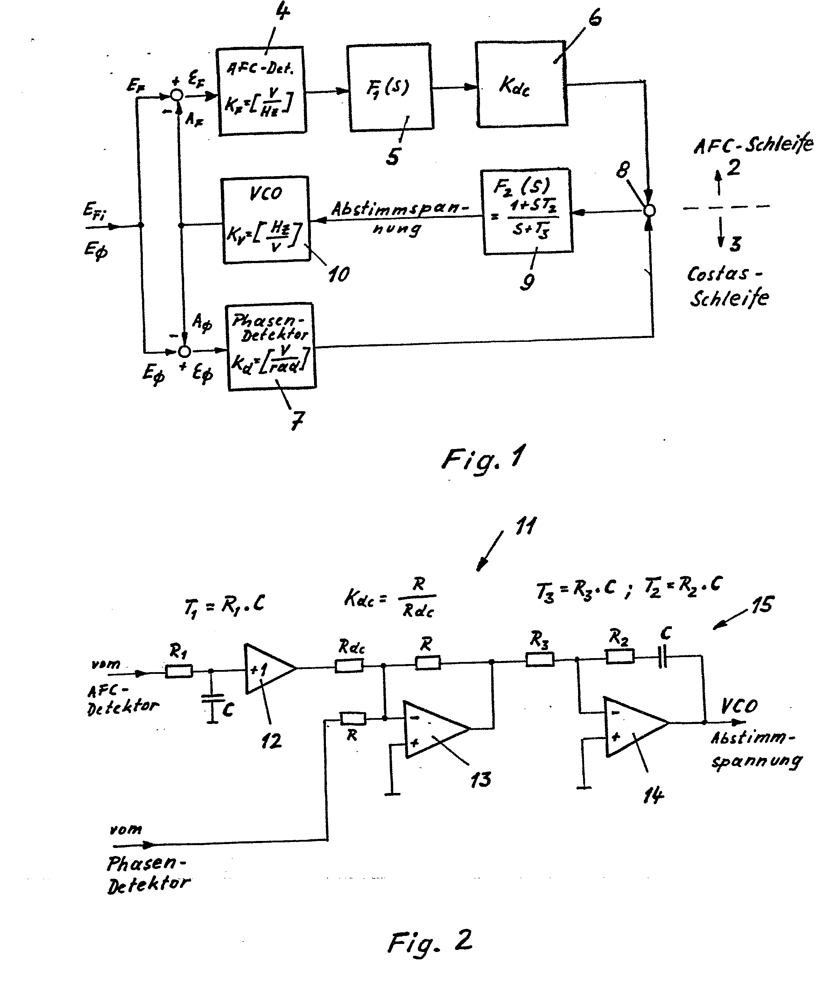

Aus Figur 1 ist ein Blockschaltbild der Schaltungsanordnung
1 einer AFC- und Costas-Phasenregelschleife 2 und 3 ersichtlich. Voneinander getrennt kommen die vom AFC-Detektor 4
über einen passiven Integrator 5 mit der Funktion $F_1(s)$ und
einen frequenzunabhängigen Gleichspannungsverstärker 6 ($K_{dc}$)
und die vom Costas-Detektor 7 abgegebenen und aus Frequenzfehler $\varepsilon_F$ und Phasenfehler $\varepsilon_\phi$ resultierenden Fehlerspannungen am Summationspunkt 8 an und werden hier addiert.
Von hier gelangen diese Fehlerspannungen in das Schleifenfilter 9 mit der Funktion $F_2(s)$ und als Abstimmspannung
weiter zum spannungsabgestimmten Oszillator 10 (VCO).


Anhand eines Berechnungsbeispiels soll die Dimensionierung
dieser Schaltungsanordnung 1 im folgenden dargestellt werden.
Dazu wird zweckmässigerweise zunächst das Schleifenfilter 9
(Loopfilter) mit der Funktion $F_2(s)$ für die Costas-Schleife
(-Loop) 3 bestimmt. Das Verhältnis der beiden Spannungsphasen ist

$$\frac{A_\phi}{E_\phi} = \frac{K_d \cdot K_v \cdot 2\pi \cdot F_2(s)}{1 + K_d \cdot K_v \cdot 2\pi \cdot F_2(s)}$$

darin ist

$A_\phi$ = Antwortsignal des Regelkreises auf eine Änderung der Erregung

$E_\phi$ = Erregung der Costas-Schleife

$K_d$ = Detektorgewinn des Costas-Detektors

$K_v$ = Oszillatorgewinn (VCO)

$F_2(s)$ = frequenzabhängige Filterfunktion (Schleifenfilter).

Bei Anwendung eines Schleifenfilters mit der Übertragungsfunktion $F_2(s) = \dfrac{1+sT_2}{sT_3}$ , worin $T_2$ und $T_3$ Zeitkonstanten sind, ergibt sich daraus die Übertragungsfunktion als

$$\frac{A_\phi}{E_\phi} = \frac{K_d \cdot \dfrac{K_v \cdot 2\pi}{s} \cdot \left[\dfrac{1+sT_2}{sT_3}\right]}{1 + K_d \cdot \dfrac{K_v \cdot 2\pi}{s} \cdot \left[\dfrac{1+sT_2}{sT_3}\right]}$$

Dies führt zu der klassischen Form eines Verzögerungsgliedes zweiter Ordnung mit

$$\frac{A_\phi}{E_\phi} = K_d \cdot K_v \cdot 2\pi \cdot \frac{1}{T_3} \cdot \frac{1 + sT_2}{s^2 + s \cdot K_d \cdot K_v \cdot 2\pi \cdot \dfrac{T_2}{T_3} + \dfrac{K_d \cdot K_v \cdot 2\pi}{T_3}}$$

worin für $\dfrac{K_d \cdot K_v \cdot 2\pi}{T_3} = \omega_c^2$

und $\dfrac{T_2}{2} \cdot \sqrt{\dfrac{K_d \cdot K_v \cdot 2\pi}{T_3}} = \xi$

gesetzt werden und worin $\omega_c$ die Schleifenresonanzfrequenz und $\xi$ die Dämpfung der Costas-Schleife 3 ist.

Bei Vorgabe gewünschter Schleifenfrequenz $\omega_c$ und Dämpfung der Costas-Schleife $\zeta$ ergibt sich somit für die Zeitkonstanten

$$T_3 = \frac{K_d \cdot K_v \cdot 2\pi}{\omega_c^2} \quad \text{und} \quad T_2 = \frac{2\zeta}{\omega_c}$$

Die Zeitkonstanten $T_3$ und $T_2$ sind damit durch die Dimensionierung der Costas-Schleife 3 festgelegt.

Als nächster Schritt wird die AFC-Schleife 2 mit den bereits festgelegten Zeitkonstanten $T_3$ und $T_2$ dimensioniert. Aus dem Schaltbild der Figur ergibt dies für die AFC-Frequenzregelschleife 2 folgende Übertragungsfunktion:

$$\frac{A_F}{E_F} = \frac{K_F \cdot K_v \cdot K_{dc} \cdot F_1(s) \cdot F_2(s)}{1 + K_F \cdot K_v \cdot K_{dc} \cdot F_1(s) \cdot F_2(s)}$$

darin ist

$A_F$ = Antwortsignal der AFC-Schleife auf eine Erregung $E_F$

$E_F$ = Änderung der detektierten Signalfrequenz (Erregung)

$K_F$ = Detektorgewinn des AFC-Detektors

$K_{dc}$ = frequenzunabhängige Gleichspannungsverstärkung

$F_1(s)$ = passiver Integrator (RC-Tiefpaß).

Wird für das Produkt $K_A = K_F \cdot K_v \cdot K_{dc}$ gesetzt und für

$F_1(s) = \dfrac{1}{1+sT_1}$ (als passiver RC-Tiefpaß) und für

$F_1(s) = \dfrac{1+sT_2}{sT_3}$ , so ergibt dies

$$\frac{A_F}{E_F} = \frac{K_A}{T_1 \cdot T_3} \cdot \frac{1 + sT_2}{s^2 + s \cdot \dfrac{T_3 + K_A \cdot T_2}{T_1 \cdot T_3} + \dfrac{K_A}{T_1 \cdot T_3}}$$ worin

$T_1$ = Zeitkonstante für RC-Tiefpaß ist.

Wie vorher bei der Bestimmung des Schleifenfilters 9 ($F_2(s)$) ist dies die Übertragungsfunktion eines Verzögerungsgliedes zweiter Ordnung, wobei gesetzt werden kann:

$$2\, \zeta \cdot \omega_A = \frac{T_3 + K_A \cdot T_2}{T_1 \cdot T_3} \quad ; \quad \omega_A^2 = \frac{K_A}{T_1 \cdot T_3}$$

und worin $\omega_A$ die Schleifenfrequenz und $\zeta$ die Dämpfung der AFC-Schleife ist.

Da $T_2$ und $T_3$ vorgegeben sind, ist

$$K_A = \frac{T_3}{\dfrac{2\zeta}{\omega_A} - T_2} \quad \text{und}$$

$$T_1 = \frac{1}{\omega_A^2 \left[ \dfrac{2\zeta}{\omega_A} - T_2 \right]}$$

Weil $K_A$ und $T_1$ positive Grössen sein müssen, ist die Bedingung zu erfüllen für

$$\frac{2\zeta}{\omega_A} - T_2 > 0$$

Wird für $T_2$ die entsprechende Formel für die Dimensionierung der Costas-Schleife eingesetzt, so muß sein

$$\frac{\zeta}{\omega_A} - \frac{\xi}{\omega_C} > 0$$

Sind $\zeta$ und $\xi$ gleich ($\zeta = \xi$), so folgt daraus: $\omega_A < \omega_C$.

Wird für das Verhältnis eine feste Beziehung mit $M = \dfrac{\omega_C}{\omega_A}$ eingeführt, so ergibt dies für

$$K_A \quad = \quad \frac{K_d \cdot K_v \cdot 2\pi}{\omega_C \left[\zeta \cdot M - \xi\right]} \qquad \text{und weil}$$

$$K_A \quad = \quad K_F \cdot K_{dc} \cdot K_v \quad \text{ist, wird}$$

$$K_{dc} \quad = \quad \frac{K_d}{K_F} \cdot \frac{\pi}{\omega_C \left[\zeta \cdot M - \xi\right]}$$

Für $T_1$ ergibt dies somit

$$T_1 \quad = \quad \frac{M^2}{2\,\omega_C \cdot \left[\zeta \cdot M - \xi\right]}$$

Zur Einstellung der Spannungsverstärkung $K_{dc}$ wird vorteilhafterweise die analoge Additionsschaltung verwendet, die ohnehin für die rückwirkungsfreie Summierung der Fehlerspannungen aus dem AFC- und Costas-Detektoren benötigt wird.

Aus Figur 2 ist im Prinzip eine vor der AFC- und Costas-Schleife 2, 3 im Summationspunkt 8 (Figur 1) geschaltete Schleifenfilteranordnung 11 ersichtlich. Die vom AFC-Detektor 4 (Figur 1) abgegebene Fehlerspannung gelangt über das aus einem Widerstand $R_1$, einem Kondensator C und einem Impedanzwandler (+1) 12 bestehende Zeitglied $T_1 = R_1 \cdot C$ in das spannungsverstärkende und aus Widerständen $R_{dc}$, R, R und Operationsverstärker ($\overline{+}$) 13 bestehende Glied $K_{dc} = \dfrac{R}{R_{dc}}$ , in welches die vom Phasendetektor abgegebene Fehlerspannung über die Widerstände R, R und dem Operationsverstärker ($\overline{+}$) 13 gelangt und hierin zu der AFC-Fehlerspannung addiert wird. Vom spannungsverstärkenden Glied 6 $K_{dc}$ (Figur 1) gelangen die so addierten Fehlerspannungen in den aus den Widerständen $R_3$, $R_2$, einem weiteren Operationsverstärker ($\overline{+}$) 14 und einem Kondensator C bestehenden Integrator 15 ($T_3 = R_3 \cdot C$ bzw. $T_2 = R_2 \cdot C$) und von hier als Abstimmspannung zum spannungsabgestimmten Oszillator 10 (VCO) (Figur 1).

16.02.1984

DORNIER SYSTEM GMBH

7990 Friedrichshafen

Reg. S 466

P a t e n t a n s p r ü c h e :

1. Schaltungsanordnung für einen Regelkreis, enthaltend
eine mit einem AFC- und Costas-Phasen-Detektor und
einem gemeinsamen Integrator-Schleifenfilter kombinierte
Regelschleife, d a d u r c h   g e k e n n z e i c h -
n e t,  dass von AFC- und Costas-Phasen-Detektor (4, 7)
abgegebene Fehlerspannungen vor dem gemeinsamen Integrator-Schleifenfilter (9) addiert werden.

2. Schaltungsanordnung nach Anspruch 1, dadurch gekennzeichnet, dass durch Einführung eines zweiten, passiven
Integrators (5) in der AFC-Schleife (2) eine Übertragungsfunktion zweiter Ordnung erzwungen wird.

Fig. 1

Fig. 2